(19) **Europäisches Patentamt / European Patent Office / Office européen des brevets**

(11) **EP 1 605 079 B1**

(12) **EUROPEAN PATENT SPECIFICATION**

(45) Date of publication and mention of the grant of the patent:
**10.12.2008 Bulletin 2008/50**

(51) Int Cl.:
**C30B 29/06** (2006.01)    **C30B 15/22** (2006.01)

(21) Application number: **05253486.4**

(22) Date of filing: **07.06.2005**

(54) **Method and apparatus for growing silicon crystal by controlling melt-solid interface shape as a function of axial length**

Verfahren und Vorrichtung zur Züchtung eines Silicium-Einkristalls durch die Steuerung der Form des Schmelz-Festphase Übergangsbereichs als Funktion der axialen Länge

Procédé et dispositif pour la croissance d'un monocristal de silicium faisant appel au contrôle de la forme de l'interface phase fondue-solide en fonction de la longueur axiale.

(84) Designated Contracting States:
**DE FR GB IT**

(30) Priority: **07.06.2004 US 577722 P**
**03.06.2005 US 145626 P**

(43) Date of publication of application:
**14.12.2005 Bulletin 2005/50**

(73) Proprietor: **MEMC Electronic Materials, Inc.**
**St. Peters,**
**Missouri 63376 (US)**

(72) Inventors:
• **Kulkarni, Milind**
 **MEMC Electronic Material, Inc.**
 **St. Peters**
 **Missouri 63376 (US)**
• **Nithiananthan, V.**
 **MEMC Electronic Material, Inc.**
 **St. Peters**
 **Missouri 63376 (US)**
• **Ferry, Lee W.**
 **MEMC Electronic Material, Inc.**
 **St. Peters**
 **Missouri 63376 (US)**
• **Ryu, JaeWoo**
 **MEMC Electronic Material, Inc.**
 **St. Peters**
 **Missouri 63376 (US)**
• **Uhm, Jin Yong**
 **MEMC Electronic Material, Inc.**
 **St. Peters**
 **Missouri 63376 (US)**

• **Kimbel, Steven L.**
 **MEMC Electronic Material, Inc.**
 **St. Peters**
 **Missouri 63376 (US)**
• **Kim, ChangBum**
 **MEMC Electronic Material, Inc.**
 **St. Peters**
 **Missouri 63376 (US)**
• **Holzer, Joseph C.**
 **MEMC Electronic Material, Inc.**
 **St. Peters**
 **Missouri 63376 (US)**
• **Schrenker, R. G.**
 **MEMC Electronic Material, Inc.**
 **St. Peters**
 **Missouri 63376 (US)**
• **Lee, KangSeon**
 **MEMC Korea Company**
 **Chonan City**
 **ChungchongNam-Do, 330-831 (KR)**

(74) Representative: **Smaggasgale, Gillian Helen**
 **W.P. Thompson & Co,**
 **55 Drury Lane**
 **London WC2B 5SQ (GB)**

(56) References cited:
EP-A- 0 247 297       EP-A- 0 732 427
EP-A- 0 890 662       WO-A-00/22201
US-A- 5 766 341

**Description**

FIELD OF THE INVENTION

The present invention generally relates to producing semiconductor grade single crystal silicon that can be used in the manufacture of electronic components and the like. More particularly, the present invention relates to processes for producing silicon ingots by controlling the shape of the melt-solid interface in a selected thermal environment.

BACKGROUND OF THE INVENTION

Single crystal silicon, which is the starting material for most processes for the fabrication of semiconductor electronic components, is commonly prepared by the so-called Czochralski ("Cz") method. In this method, polycrystalline silicon ("polysilicon") is charged to a crucible and melted, a seed crystal is brought into contact with the molten silicon and a single crystal is grown by slow extraction. Silicon crystals grown from a melt may be grown with an excess of one or the other type of intrinsic point defect, either crystal lattice vacancies ("V") or silicon self-interstitials ("I") and may have regions of both or of neither. It has been suggested that the dominant point defect type is determined near solidification and, if the dominant-point defect concentrations reach a level of critical supersaturation in the system and the mobility of the point defects is sufficiently high, a reaction, or an agglomeration event, will likely occur. Agglomerated intrinsic point defects in silicon can severely impact the yield potential of the material in the production of complex and highly integrated circuits.

Those skilled in the art are familiar with the ratio of the pull rate v of the crystal to an axial thermal gradient G being indicative of the type of intrinsic point defect likely to occur in the growing crystal. For example, when the pull rate is high lattice vacancies are the dominant point defects. Alternatively, when pull rate is low silicon self interstitials are the dominant point defects. Thus, during a dynamic growth process (i.e., where v/G may vary as a function of the radius and/or axial length of the crystal) point defects within the growing silicon crystal can change from being vacancy dominated to interstitial dominated, or vice versa. Moreover, there is an identifiable vacancies/self interstitials (V/I) transition associated with such a change.

EP089662 describes a method for manufacturing a single crystal in accordance with a Czochralski method in which, during the growth of the silicon single crystal, pulling is performed such that a solid-liquid interface in the crystal, excluding a peripheral 5mm-width portion, exists within a range of an average vertical position of the solid-liquid interfaces 5mm. There is also disclosed a method for manufacturing a silicon single crystal in accordance with the Czochralski method, characterized in that during the growth of a silicon single crystal, a furnace temperature is controlled such that a temperature gradient difference $\Delta G$ (= Ge - Gc) is not greater that 5°C/cm, where Ge is a temperature gradient (°C/cm) at a peripheral portion of the crystal, and Gc is a temperature gradient (°C/cm) at a central portion of the crystal, both in an in-crystal descending temperature zone between 1420°C and 1350°C or between a melting point of silicon and1400°C in the vicinity of the solid-liquid interface of the crystal. The method is said to maintain high productivity and enables a silicon single crystal and silicon wafers to be manufactured such that a defect density is very low over the entire crystal cross section, and the oxygen concentration distribution over the surface of each silicon wafer is improved.

US5766341 describes apparatus and methods for pulling a semiconductor crystal according to a Czochralski method. The apparatus includes a crucible containing a melt, a crystal pulling mechanism which pulls the semiconductor crystal from the melt, a motor coupled to the crucible, and a control circuit for energizing the motor to rotate the crucible at a variable speed. The control circuit may energize the motor to rotate the crucible at a continuously varying acceleration and continously varying rotational speed while the crystal pulling mechanism is pulling at least a portion of the semiconductor crystal from the melt in the crucible. The control circuit may also energize the motor to rotate the crucible at a rotational speed which monotonically increases and decreases. A method for pulling a semiconductor crystal is also disclosed which includes the steps of performing a Fourier analysis on a periodic signal for variably rotating a crucible; generating a sine wave which corresponds to a fundamental Fourier frequency of the periodic signal; and energizing the crucible motor to rotate the crucible at a rotational speed which increases and decreases as a function of the generated sine wave. Other apparatus and methods for pulling crystals with the CZ method to acheive a desired oxygen concentration and gradient are also disclosed.

WO00/22201 describes a method and apparatus for accurately pulling a monocrystalline ingot in a Czochralski crystal growing apparatus. The crystal growing apparatus has a cable wound on a drum for raising and lowering the ingot relative to the melt. A motor rotates the drum at a varying speed to pull the ingot from the melt at a varying rate and a detector detects rotational movement of the drum for generating a position signal. A memory stores a predetermined velocity profile that defines a target rate for pulling the ingot from the melt as a function of ingot length. A controller responsive to the position signal and the velocity profile controls motor speed for pulling the ingot. The controller determines an actual pull rate based on the position signal and compares it to the target pull rate defined by the velocity profile. The controller then controls motor speed to maintain the actual pull rate of the ingot approximately equal to the target pull rate during the pulling of at least 50% of the length of the ingot. Calibration is permitted by setting a nominal pull rate, energizing the motor as a function of a set point corresponding to the nominal pull rate and adjusting the set point until the difference between the actual pull rate and the nominal pull rate is less than or equal to a threshold level.

## SUMMARY OF THE INVENTION

In accordance with the present invention, it has been discovered that substantially defect-free single silicon crystals can be produced by closely controlling the shape of the molten silicon/silicon crystal (melt/crystal or melt-solid) interface. In particular, by controlling the melt-solid interface shape according to a target melt-solid shape profile as a function of axial length, a region substantially free of agglomerated defects may be produced. Further, by selecting a smooth seed lift profile that is determined using the V/I transition pull rate values, perfect silicon material may be produced over substantially all of the crystal body length. The target interface shape is unique to the crystal hotzone design and position along the axial length of the ingot.

According to the present invention, there is provided a method for use in combination with a crystal growing apparatus for growing a monocrystalline ingot according to the Czochralski process, said crystal growing apparatus having a heated crucible containing a semiconductor melt from which the ingot is pulled, said ingot being grown on a seed crystal pulled from the melt, said method comprising the steps of:

defining a melt-solid interface shape profile, said melt-solid interface shape profile representing a plurality of desired shapes of a melt-solid interface between the melt and the ingot during pulling as a function of the length of the ingot and an operating condition affecting the melt;
determining a particular axial position along the length of the ingot, said axial position along the length of the ingot corresponding to at least one of the plurality of desired shapes in the defined melt-solid interface shape profile;
determining a set point for an operating parameter of the crystal growing apparatus for controlling the operating condition affecting the melt at the axial position along the length of the ingot during pulling, said set point being specified by the melt-solid interface shape profile; and
adjusting the operating condition of the crystal growing apparatus according to the determined operating parameter set point to control the melt-solid interface for achieving the desired shape at the axial position while the ingot is being pulled from the melt.

According to a further aspect of the present invention, there is provided a system for use in combination with a crystal growing apparatus for limiting formation of defects during growing a monocrystalline ingot according to the Czochralski process, said crystal growing apparatus having a heated crucible containing a semiconductor melt from which the ingot is pulled, said ingot being grown on a seed crystal pulled from the melt, said crystal growing apparatus further having a controller for adjusting an operating condition of the crystal growing apparatus, said system comprising:

a memory storing a pre-defined melt-solid interface profile, said melt-solid interface profile representing a plurality of desired shapes of a melt solid interface between the melt and the ingot during pulling as a function of a length of the ingot and an operating condition affecting the melt;
a processor responsive to the pre-defined melt-solid interface profile for determining a particular axial position along the length of the ingot corresponding to at least one of the plurality of desired shapes in melt-solid shape interface profile and determining a set point for an operating parameter of the crystal growing apparatus for controlling the operating condition affecting the melt at the axial position along the length of the ingot during pulling; and
wherein said controller is responsive to the determined operating parameter set point to adjust the operation condition of the crystal growing apparatus according to the determined operating parameter set point to control the melt-solid interface for achieving the desired shape at the axial position while the ingot is being pulled from the melt.

## BRIEF DESCRIPTION OF THE DRAWINGS

FIG. 1 is an illustration of a crystal growing apparatus and an apparatus according to an embodiment of the present invention for controlling the crystal growing apparatus.

FIG. 2 illustrates an exemplary growing single silicon crystal 31 having a concave melt-solid interface shape relative to the crystal.

FIG. 3A illustrates modeling components of a V/I simulator for generating an expected V/I transition according to an embodiment of the invention.

FIG. 3B illustrates various exemplary molten silicon/silicon crystal interface shapes for analyses by the V/I simulator of FIG. 3.

FIG. 3C illustrates a vertical component and a horizontal component corresponding to one data point of a series of data points defining an exemplary assumed molten silicon/silicon crystal interface shape.

FIG. 3D illustrates an exemplary velocity profile for pulling single crystal silicon ingot 31 to force a V/I transition during a simulated growth process.

FIG. 3E illustrates an exemplary V/I transition plot generated by the V/I simulator in response to an assumed melt-solid interface shape.

FIG 4A illustrates various melt-solid interface shapes corresponding to an exemplary melt-solid interface shape profile for growing a single crystal silicon ingot.

FIG 4B illustrates a cropped vertical section of an ingot subj ected to a precipitation thermal cycle for measuring the melt interface shapes at various axial positions.

FIG. 5A illustrates components of the control system for controlling the melt-solid interface shape of a crystal according to one preferred embodiment of the invention.

FIG. 5B is an exemplary graph illustrating changes in melt-solid interface shape as function of changes in crucible surface temperature being supplied from a bottom heater, or by a change in lower insulation.

FIG. 5C is an exemplary graph illustrating changes in melt-solid interface shape as function of changes in the magnet field being applied by a magnet.

FIG. 5D is an exemplary graph illustrating changes in melt-solid interface shape as function of a rotation speed differential between the crucible and the crystal.

FIG. 5E is an exemplary graph illustrating the increased range over which the interface shapes can be controlled during an iso-rotation process.

FIG. 6 is an exemplary flow chart illustrating a method for defining a melt-solid interface shape profile for use in combination with a crystal growing apparatus when growing a monocrystalline ingot according to the Czochralski process according to one embodiment of the invention.

FIG. 7 is an exemplary graph illustrating measured interface shapes of a crystal and a point defect concentration field generated by a point defect simulator as a function of the measured interface shapes.

Corresponding reference characters indicate corresponding parts throughout the several views of the drawings.

DETAILED DESCRIPTION OF THE INVENTION

Single crystal silicon, which is the starting material for most processes for the fabrication of semiconductor electronic components, is commonly prepared by the so-called Czochralski ("Cz") method. In this method, polycrystalline silicon ("polysilicon") is charged to a crucible and melted, a seed crystal is brought into contact with the molten silicon and a single crystal is grown by slow extraction. The present invention proposes a method and system for producing silicon crystal ingots suitable for use in device manufacturing. In some embodiments, the method and system of the present invention may be used to produce a silicon crystal ingot, a substantial portion or all of which is substantially free of agglomerated intrinsic point defects. That is, silicon ingots, a substantial portion or all of which is has a density of defects of less than about $1 \times 10^4$ defects/cm$^3$, less than about $5 \times 10^3$ defects/cm$^3$, less than about $1 \times 10^3$ defects/cm$^3$ or even no detectable agglomerated intrinsic point defects). In other embodiments, the present invention may produce silicon ingots having substantially no agglomerated defects that are larger than about 60 nm in diameter.) More specifically, the present invention can control the shape of the molten silicon and crystal (melt-solid) interface during crystal growth to limit and/or suppress the formation of agglomerated intrinsic point defects. The melt-solid interface shape may be concave, convex in shape relative to the crystal, and may even be both concave and convex in shape relative to the crystal (e.g., a "sea gull wing" shape). It has been discovered that the melt-solid interface shape is an important parameter for controlling defects during crystal growth.

The shape of melt-solid interface can be affected significantly by melt convection. Convection refers to the process of heat transfer in a liquid by the movement of the liquid itself. In general, there are two types of convection: natural convention and forced convection. Natural convection is when the movement of the melt is due, for example, solely to the presence of heaters giving rise to density gradients. Forced convection is when the movement of the melt is due to an external agent such as magnetic fields in the crucible, or rotational speed and or direction of the ingot and/or crucible. Accordingly, the shape of the melt-solid interface may be controlled by controlling one or more of at least four (4) operational parameters, which can be used alone, or in combination, to achieve the desired shape of melt-solid interface shape. These parameters include (1) heat flux, which determines the melt boundary temperature field, generated by either a change in lower heater power or by a change in lower insulation level or efficiency (e.g., adjust bottom heater output); (2) magnetic field strength; (3) rotation of the crucible; and (4) rotation of the silicon crystal.

For instance, because magnetic fields can affect the flow pattern in electrically conducting fluids such as silicon melt, a magnet (e.g., Cusp type, Vertical type and Horizontal type) can be used to affect melt convection, and, thus change the temperature distribution in the melt, which, in turn, can affect on the melt-solid interface shape. Similarly, crucible and crystal rotation influences the flow pattern in of the, and, thus, affect the temperature distribution in the melt, which, again, affects the melt-solid interface shape. Conventionally, the crucible and crystal are rotated in opposite directions when growing a silicon single crystal. This process is referred to herein as counter-rotation. Although controlling the difference between the rotational rate of the crucible and the rotational rate crystal in a counter rotation process may be used to affect on the shape the melt-solid interface, it has been discovered by the inventors that a so-called iso-rotation process provides for greater control of the melt-solid interface shape. In an iso-rotation process, both the crucible and crystal (i.e., seed) are rotated in the same direction and the difference between the rotational rate of the crucible and the rotational rate crystal may be used to affect on the shape the melt-solid interface.

Silicon crystals grown from a melt may be grown with an excess of one or the other type of intrinsic point defect, either crystal lattice vacancies ("V") or silicon self-interstitials ("I") and may have regions of both or of neither. According to one or more embodiments of the present invention, the crystal/melt interface shape may be controlled during the growth of the crystal to control the initial distribution of point defects at solidification front and diffusion path of point defects at several degrees or tens of degrees from the melt-solid interface. It has been suggested that the dominant point defect type is determined near solidification and, if the dominant-point defect concentrations reach a level of critical supersaturation in the system and the mobility of the point defects is sufficiently high, a reaction, or an agglomeration event, will likely occur. Agglomerated intrinsic point defects in silicon can severely impact the yield potential of the material in the production of complex and highly integrated circuits. By controlling the shape of the melt-solid interface, the agglomeration reaction may be greatly reduced and even avoided entirely, producing silicon substantially free of agglomerated intrinsic point defects.

Those skilled in the art are familiar with the ratio of the pull rate ν of the crystal to an axial thermal gradient G being indicative of the type of intrinsic point defect likely to occur in the growing crystal. For example, when the pull rate is high lattice vacancies are the dominant point defects. Alternatively, when pull rate is low silicon self-interstitials are the dominant point defects. Thus, during a dynamic growth process (i.e., where ν/G may vary as a function of the radius and/or axial length of the crystal) point defects within the growing silicon crystal can change from being vacancy dominated to interstitial dominated, or vice versa. Moreover, there is an identifiable vacancies/self-interstitials (V/I) transition associated with such a change. It has been discovered that a defect free region exists between agglomerated vacancy defects and agglomerated interstitial type defects. Significantly, the V/I transition occurs within this defect-free region. That is, this defect free region corresponds to the transition region from an excess vacancy dominant region to an excess interstitial dominant region. The defect-free region may be vacancy dominated and/or interstitial dominated material. The defect-free region does not contain critical excess point defects to form any defects and generally includes the V/I transition.

Moreover, it has been discovered that when the identified V/I transition has a preferred shape, or profile, the crystal is substantially free of agglomerated defects at this transition. For instance, a substantially flat V/I transition perpendicular to the pull axis under dynamic growth simulations corresponds to a portion of the crystal substantially free of agglomerated defects.

According to the present invention, a target interface shape is determined for a particular hotzone at various positions along the length of the crystal to determine the target interface shape profile for the given hotzone. By suppressing or otherwise controlling the agglomeration reactions that produce agglomerated defects, rather than simply limiting the rate at which such defects form, or attempting to annihilate some of the defects after they have formed, a method acting to suppress or control agglomeration reactions yields a silicon substrate that is substantially free of undesirable amounts or sizes of agglomerated intrinsic point defects. Such a method also affords single crystal silicon wafers having epi-like yield potential, in terms of the number of integrated circuits obtained per wafer, without having the high costs associated with an epitaxial process.

According to one embodiment of the invention, the melt-solid interface shape is controlled within a certain range or percentage of a height deviation ratio (HDR). For example, the molten silicon is controlled for a 200 mm crystal such that the height deviation ratio (HDR) ratio between crystal center and edge is about plus or minus about 11 %, preferably about plus or minus about 9%, more preferably plus or minus about 7%, and most preferably plus or minus about 5%.. Where the height deviation ratio is determined from the following equation:

$$ \text{HDR} = [\text{Hc} - \text{He}] \,/\, \text{Radius} \; X \; 100, \tag{1}; $$

where He is height of crystal center from melt surface and He is height of crystal edge from melt surface. For crystals having a diameter other than 200 mm, the maximum height deviation ratio is gradually decreased by a slope of -0.06 by the crystal radius.

In another embodiment, an acceptable range or operating window is determined as described in APPENDIX A.

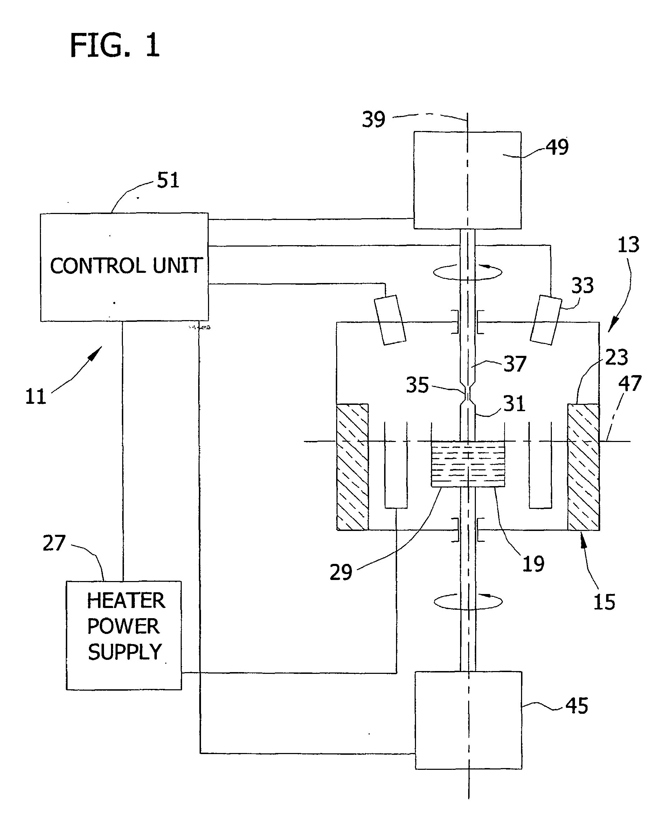

Referring now to FIG. 1, a system, indicated generally at 11, is shown for use with a Czochralski crystal growing apparatus, indicated generally at 13. In general, crystal growing apparatus 13 includes a vacuum chamber 15 enclosing a crucible 19. Heating means such as a resistance heater 21 surrounds the crucible 19. In one embodiment, insulation 23 lines the inner wall of vacuum chamber 15 and a chamber cooling jacket (not shown) fed with water surrounds it. A vacuum pump (not shown) typically removes gas from within the vacuum chamber 15 as an inert atmosphere of argon gas is fed into it. According to the Czochralski single crystal growth process, a quantity of polycrystalline silicon, or polysilicon, is charged to crucible 19. A heater power supply 27 provides electric current through the resistance heater 21 to melt the charge and, thus, form a silicon melt 29 from which a single crystal 31 is pulled. Typically, a temperature sensor 33, such as a photocell or pyrometer, is to be used to provide measurements of the melt surface temperature. The single crystal 31 starts with a seed crystal 35 attached to a pull shaft, or cable, 37. As shown in FIG. 1, single crystal 31 and crucible 19 generally have a common axis of symmetry 39. One end of cable 37 is connected by way of a pulley (not shown) to a drum (not shown) and the other end is connected to a chuck (not shown) that holds the seed crystal 35 and the crystal 31 grown from the seed crystal.

During both heating and crystal pulling, a crucible drive unit (i.e., motor) 45 rotates crucible 19 (e.g., in the clockwise direction). The crucible drive unit 45 may also raise and/or lower the crucible 19 as desired during the growth process. For example, crucible drive unit 45 raises crucible 19 as the melt 29 is depleted to maintain its level, indicated by reference character 47, at a desired height. A crystal drive unit 49 similarly rotates the cable 37 in a direction opposite the direction in which crucible drive unit 45 rotates crucible 19 (e.g., in the counter-clockwise direction) or in the same direction as the crucible drive (e.g., iso-rotation). In embodiments using iso-rotation, the crystal drive unit 49 may rotate the cable 37 in the same direction in which crucible drive unit 45 rotates crucible 19 (e.g., in the clockwise direction) In addition, the crystal drive unit 49 raises and lowers crystal 31 relative to the melt level 47 as desired during the growth process.

In one embodiment, crystal growth apparatus 13 preheats the seed crystal 35 by lowering it nearly into contact with the molten silicon of melt 29 contained by crucible 19. After preheating, crystal drive unit 49 continues to lower seed crystal 35 via cable 37 into contact with melt 29 at its melt level 47. As seed crystal 35 melts, crystal drive unit 49 slowly withdraws, or pulls, it from the melt 29. Seed crystal 35 draws silicon from melt 29 to produce a growth of silicon single crystal 31 as it is withdrawn. Crystal drive unit 49 rotates crystal 31 at a reference rate as it pulls crystal 31 from melt 29. Crucible drive unit 45 similarly rotates crucible 19 at another reference rate in either the opposite direction (counter-rotation) or in the same direction (i.e., iso-rotation) relative to crystal 31. A control unit 51 of FIG. 1 initially controls the withdrawal rate and the power that power supply 27 provides to heater 21 to cause a neck down of crystal 31. Typically, crystal growth apparatus 13 grows the crystal neck at a substantially constant diameter as seed crystal 35 is drawn from melt 29. For example, the control unit 51 maintains a substantially constant neck diameter of about five percent of the desired body diameter. After the neck reaches a desired length, control unit 51 then adjusts the rotation, pull rate, and/or heating parameters to cause the diameter of crystal 31 to increase in a cone-shaped manner until a desired crystal body diameter is reached. For example, the control unit 51 decreases the pull rate to create an outwardly flaring region typically referred to as the taper of the crystal. Once the desired crystal diameter is reached, control unit 51 controls the growth parameters to maintain a relatively constant diameter as measured by apparatus 11 until the process approaches its end. At that point, the pull rate and heating are usually increased for decreasing the diameter to form a tapered portion at the end of single crystal 31. The control unit 51 is further configured to control the process parameters that affect the shape of the melt-solid interface to achieve a target melt-solid shape profile as a function of crystal length. By controlling the melt-solid interface shape according to a target melt-solid shape profile as a function of axial length, a region substantially free of undesirable amounts or sizes of agglomerated defects may be formed in the crystal. Further, by selecting a smooth seed lift profile that is determined using the V/I transition pull rate values, perfect silicon material may be produced over substantially all of the crystal body length.

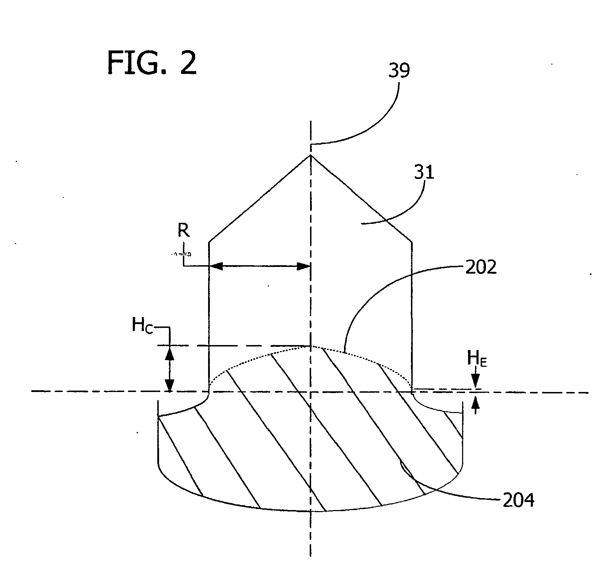

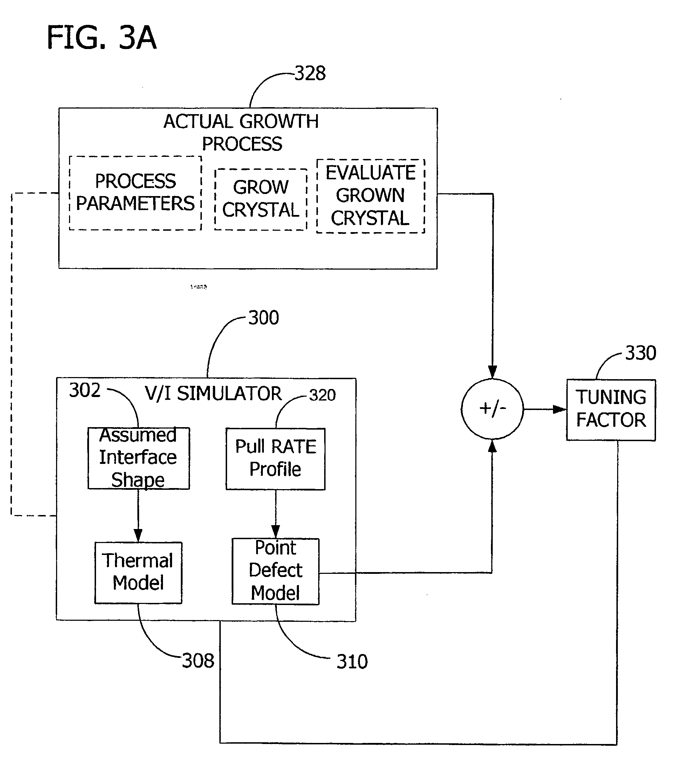

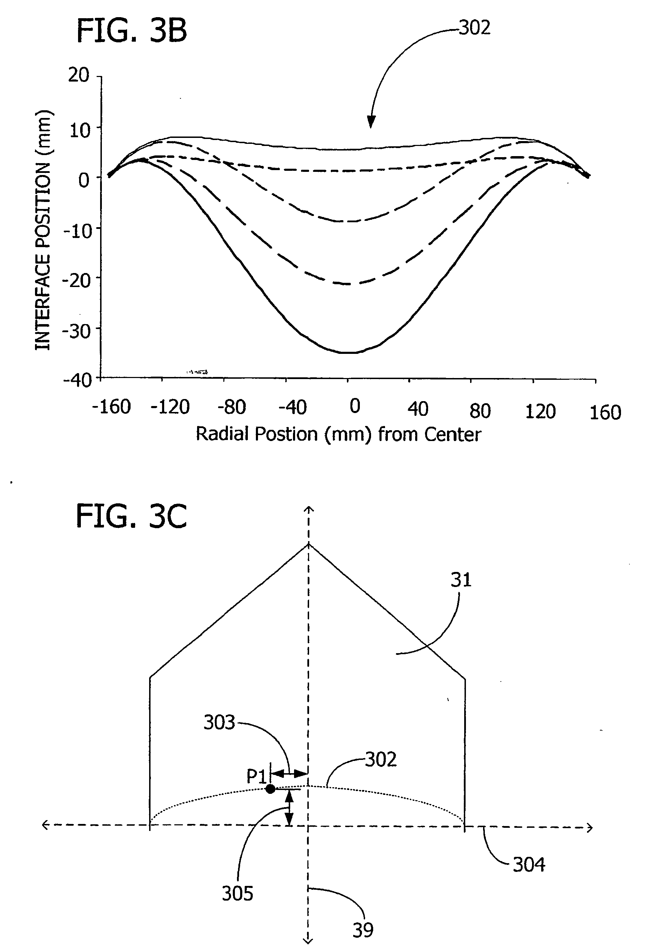

Referring now to Figure 2, there is shown a growing single silicon crystal 31 having a radius R, a concave melt-solid interface 202 relative to the crystal 31, and molten silicon melt 204. The growing crystal 31 has a height in the center from the melt surface $H_c$, and has a height from the edge to the melt surface He. He is typically not zero because as the crystal is grown and being pulled away from the melt surface, the crystal 31 is actually pulled up slightly away from the actual melt surface, which results in the edge of the growing crystal 31 being slightly above the level of molten silicon in the melt. Although, the molten silicon/silicon crystal interface 202 is shown as having a concave shape, the shape of the interface 202 may change during body growth from, for example, from concave to convex, or from convex to concave, or from concave to flat to convex etc. It should also be noted that the terms convex and concave refer to the position of the melt-solid interface at the axis of the crystal relative to the melt-solid interface at the edge of the crystal. In this regard, the melt solid interface shape may be convex to the crystal for a portion of the radius and concave to the crystal for another portion of the radius forming a "gull-wing" shape as discussed earlier. In such cases, the "gull-wing" shape is said to be concave to the crystal when the melt-solid interface at the axis of the crystal is higher than the melt-solid interface at the edge of the crystal and is said to be convex to the crystal when the melt-solid interface at the axis of the crystal is lower than the melt-solid interface at the edge of the crystal. Referring now to FIG. 3A, modeling components of a V/I simulator 300 are shown. The V/I simulator is used for generating an expected V/I transition occurring at a particular location in a growing crystal as a function of a given melt-solid interface shape associated with the particular location. In accordance with one embodiment of the invention, various molten silicon/silicon crystal interface shapes 302 are assumed (see FIG. 3B) and each assumed shape 302 is analyzed by the V/I simulator 300 to identify an target melt-solid interface shape that produces a substantially flat V/I transition when the growth parameters have been selected such that the simulated ingot transitions from vacancy dominated to interstitial dominated. As described above, it has been discovered that a substantially flat V/I transition corresponds to a region of the crystal substantially free of undesirable amounts or sizes of agglomerated defects. Each molten silicon/silicon crystal shape is represented, for example, by a series of data points each having a horizontal component x and vertical component y. Referring briefly to FIG. 3C, the horizontal component x is representative of the horizontal distance, as indicated by reference character 303, between the same point P1 and the common axis of symmetry 39. The vertical component y is representative of the vertical distance, as indicated by reference character 305, between a point P1 on the assumed molten silicon/silicon crystal interface shape 302 and a radial axis 304 perpendicular to the common axis of symmetry 39 at an axial position along the length of the crystal 31 (e.g., 100mm, 200mm, 300mm, etc.) that corresponds to the interface at the peripheral edge. The series of data points associated with a particular assumed interface shape 302 are entered into the defect model or defect simulator along with the surface temperature calculated by a thermal model 308 to generate a corresponding temperature gradient G (temperature field) wherein the growth parameters have been selected such that the simulated ingot transitions from vacancy dominated to interstitial dominated. The thermal model 308 is for example a finite element based commercial software such as MSC.MARC™ available from MSC Software Corporation located in Santa Ana, California, and modified to include radiative heat transfer in the method published by Vertsi.

In one embodiment, the defect model is a dynamic defect modeler 310 linked to the thermal model 308, and generates a point defect profile for an ingot being pulled from silicon 31 melt according to a predetermined pull rate profile 320. The defect model 310 may be either a point defect modeler or an agglomerated point defect modeler. One commercially available point defect model is included in the software package CrysVUn available from the Fraunhofer Institute for Integrated Circuits located in Erlangen, Germany. In this case, the predetermined pull rate is representative of a ramped pull rate that forces the ingot to transition from vacancy dominated to interstitial dominated, and hence generate a V/I transition profile (i.e., point defect profile).

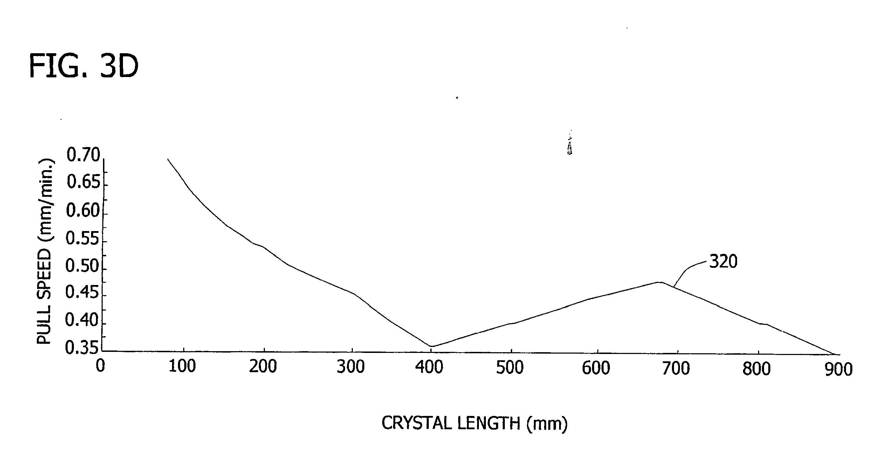

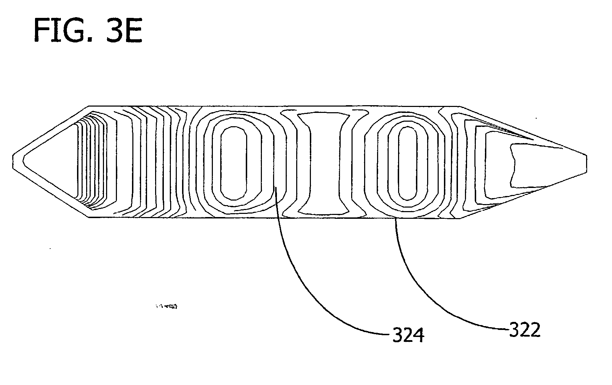

Referring briefly to FIG. 3D, an exemplary velocity profile 320 for causing V/I transitions during simulated growth is shown. As can be seen, the crystal pulling speed is ramped up and down to reveal both interstitial associated defects and vacancy associated defects in the grown crystal. Referring briefly to FIG. 3E, an exemplary V/I transition plot 322 generated by the V/I simulator 300 in response to an assumed melt-solid interface shape 302 is shown. The V/I transition plot 322 shows expected VI transition profiles, as indicated by reference character 324, at various axial positions along the crystal. As discussed above, a substantially flat V/I transition profile is indicative of a target melt-solid interface shape and target pull rate capable of producing silicon that is substantially free of relatively large or otherwise undesirable agglomerated defects in the crystal puller and at the axial position being simulated. In contrast, a V/I transition that is substantial non-flat is indicative of a melt-solid interface shape more likely to result in the formation of agglomerated intrinsic micro defects (e.g. point defects) in a portion or all of the ingot at the selected axial position. Thus, by using the V/I simulator 300 to identify a target melt-solid interface shape and target pull rate that produce a substantially flat V/I transition for each of the plurality of axial positions, a target melt-solid interface shape profile and target pull rate profile can be defined and process parameters may then be estimated stored in a memory. In one embodiment, a target melt-solid interface shape profile and a target pull rate profile may be determined for at least 2 axial positions. In other embodiments the target melt-solid interface shape profile and a target pull rate profile may be determined for at least 4 axial positions, for at least 8 axial positions and may even be determined for at least 12 axial positions or more without departing from the scope of the present invention.

In another embodiment, the defect model is a static agglomerated defect modeler such as developed at the Massachusetts Institute of Technology Cambridge, Massachusetts and described in "Modeling the Linkages between Heat Transfer and Microdefect Formation in Crystal Growth: Examples of Czochralski Growth of Silicon and Vertical Bridgman Growth of Bismuth Germanate," T. Mori, Ph. D. Thesis, Massachusetts Institute of Technology, 2000.

In the case of a static agglomerated defect model, both pull rate and the melt-solid interface shape may be analyzed by the V/I simulator to identify target melt-solid interface shapes and target pull rates at each of the various axial positions.

Moreover, the V/I simulator 300 can be fine tuned by growing a crystal 31 according to the defined profiles and comparing simulated V/I transitions to actual V/I transitions in a grown crystal 31 grown in an actual growth process 328 to determine a tuning factor 330. For example, by logging actual operating parameters during the actual growth process, and evaluating actual V/I transitions in the grown crystal the model can be fine tuned to improve the accuracy of predicted V/I transitions. In one embodiment, copper decoration and secco etching processes are used to reveal the actual V/I transitions crystal. Furthermore, actual interface shape measurements may be taken from test crystals by axial cutting of full-width thin samples, fully precipitating the oxygen in these samples, etching to remove the denuded zone, and decorative etching to show the precipitation variation at the as-grown solid-liquid interface. Based on actual transition seed lift values identified in grown crystals using metallic thermal precipitation of microdefects and subsequent decorative etching methods, a smooth seed lift profile may then be defined to achieve perfect silicon production over a majority of the crystal body length.

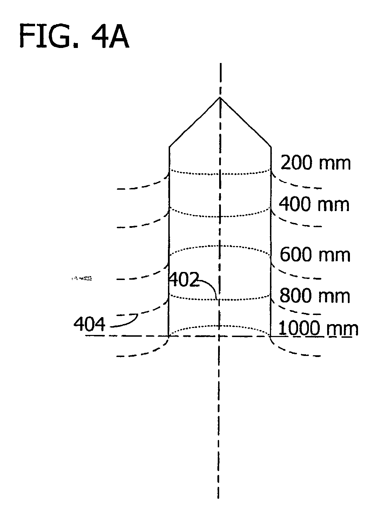

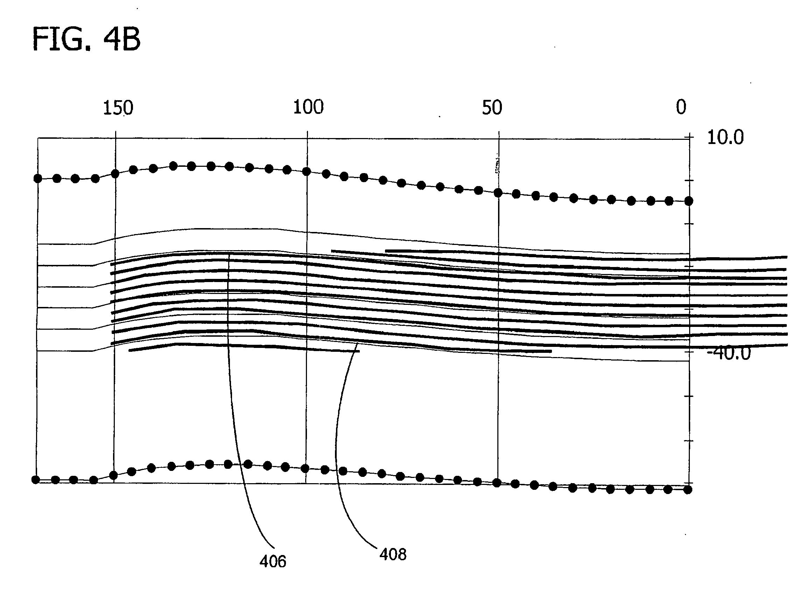

Referring now to FIG 4A, various melt-solid interface shapes corresponding to an exemplary melt-solid interface shape profile for growing a single crystal silicon ingot 31 substantially free of, for example, undesirably large agglomerated defects are shown. The profile defines a particular target melt-solid interface shape for each of a plurality of axial position along the length of the crystal 31. In this case, melt-solid interface shape profile defines target melt-solid interface shapes for a crystal at 200 mm intervals along the length of the crystal (i.e., 200 mm, 400 mm, 600mm, etc.). For example, the target molten silicon/silicon crystal interface shape at an axial position located 800 mm from the seed end is illustrated by line 402.and the corresponding melt level is indicated by line 404. Notably, each of the shapes in the profile is represented by a series of data points such as described above in reference to FIG. 3B. The actual melt-solid interface is determined post crystal growth. For example, a vertical section 406 of the ingot is cropped and subjected to a precipitation thermal cycle (See FIG. 4B). The section 405 is then imaged using a lifetime map. This image decorates the interface shape, as indicated by reference character 408 as illustrated in FIG. 4B. Thereafter interface is then measured and compared to the baseline profile (i.e., melt-solid interface shape profile).

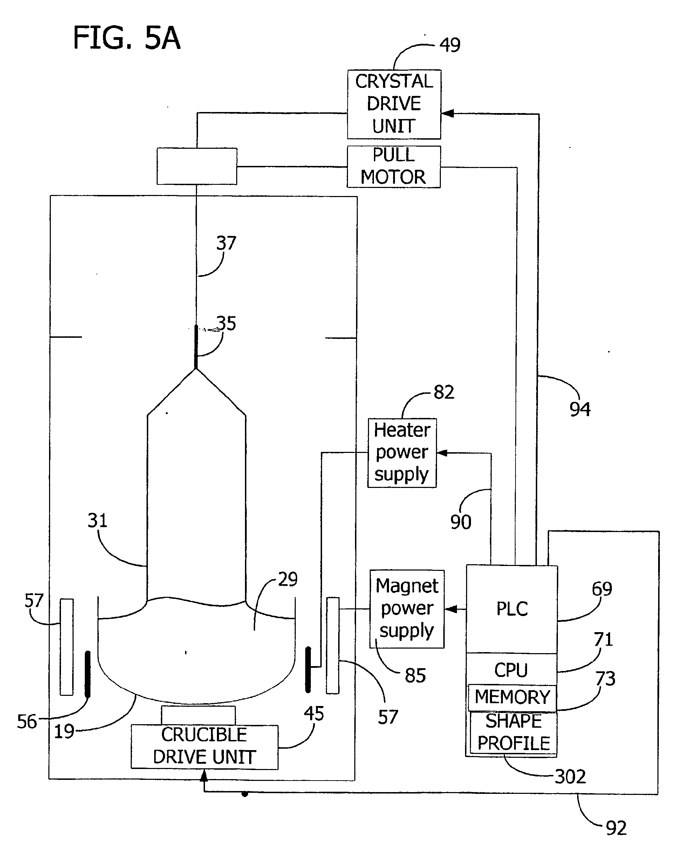

Referring next to FIG. 5A, the components of system 11 for controlling the melt-solid interface shape of a crystal according to one preferred embodiment of the invention are shown. A programmable logic controller (PLC) 69 having a central processing unit (CPU) 71 and a memory 73 is connected to output devices such crucible drive unit 45, bottom heater supply 82, crystal drive unit 49, and magnet power supply 85 for controlling the melt-solid interface shape. In this embodiment, the memory 73 stores target operating parameters required to achieve a target melt-solid interface shapes at particular axial position as defined by the melt-solid interface shape profile 302. For example, memory includes a target pull velocity, a target temperature of the melt, a target magnetic field, a target rotational speed of the ingot, a target rotational direction of the ingot, a target rotational speed of the crucible; and/or a rotational direction of the crucible. The CPU 71 and PLC 69 are responsive to the stored target parameters to adjust an operating condition of the crystal growing apparatus 13 such as heat flux to establish the desired a temperature field in the melt, a magnetic field within the crucible, a rotational speed of the ingot, a rotational direction of the ingot, a rotational speed of the crucible; and/or a rotational direction of the crucible. Such operating conditions are adjusted by adjusting the power being supplied to one or more output devices in order to achieve the targets shape at the various axial positions along the length of the crystal. For example, the CPU 71 determines a current length of the ingot from, for example, position sensors (not shown) of the crystal growing apparatus, and, thus a current axial position. The CPU 71 calculates a difference between process parameters that will establish a first target shape (e.g., height ratio) corresponding to a current position (e.g., 100 mm) along the crystal, and a second set of process parameters that will establish a second target shape corresponding to a next position (e.g. 200 mm) along the crystal to determine a set of operating parameter set points. Operating parameter set points may include, for example, a heater power set point for a heater power supply 82, a magnet power set point for a magnet power supply 85, a crucible rotational speed set point for a crucible drive unit 45, and a crystal rotational speed set point for the crystal drive unit 49. The PLC 69 is responsive to the an operating parameter set point to generate a control signal to adjust the one or more output devices affecting one or more operating conditions of the crystal growing apparatus.

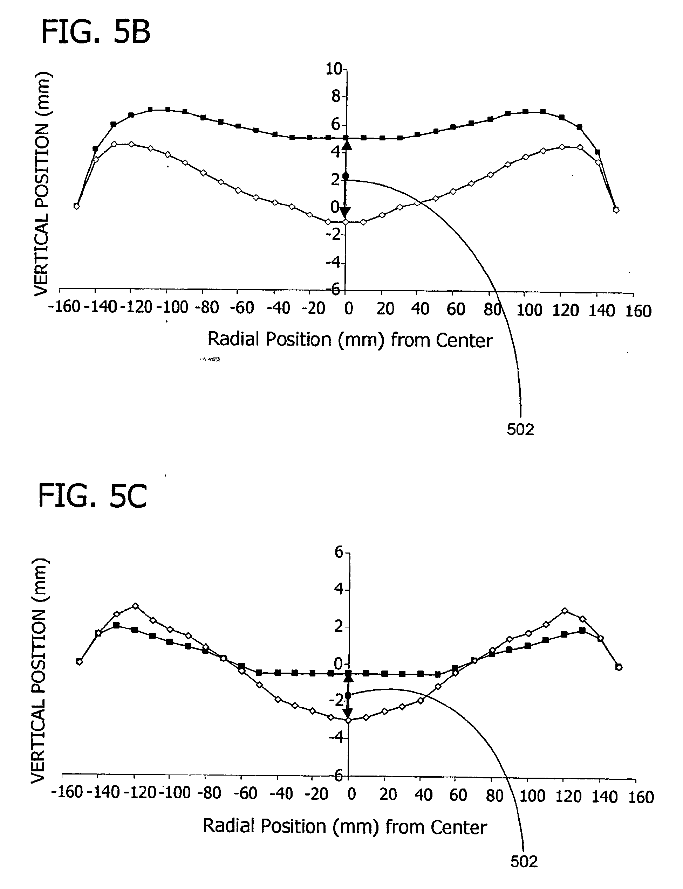

In one embodiment, the CPU 71 is responsive to the desired melt-solid interface shape profile 302 and the determined length by the storage of a desired heater power set point or profile. The PLC 69 is responsive to the heater power set point to generate a heater control signal 90 to supply to the heater power supply 82. The heater power supply 82 is responsive to the heater control signal 90 to control the current being supplied to the bottom heater 56 (e.g., resistance heater 21) surrounding the crucible 19 to control the temperature of the melt. More specifically, the heater control signal 90 controls the power being supplied to bottom heater 56 to control the temperature of the melt and a temperature profile along the crucible wall, and, thus, control the melt-solid interface shape. It has been discovered that the height of the interface increases with the heat flux from the bottom heater 56. As a result, a desired change in center height, as indicated by 502, of the interface height can be achieved by increasing power supplied to the bottom heater 56 by an amount that yields the desired change in height. For example, increasing the power to the bottom heater by 10 kilowatts, increases the height of the interface shape approximately 6mm in a 28" crucible, in a chosen hotzone configuration. (See Fig. 5B). In other words, a higher bottom heater temperature results in an increase in the height of the interface shape. The range of operation is controlled by requirements of the desired interface shape and other quality parameters, such as oxygen concentration. The estimated gain in interface height with respect to the change in heater power, is $G_{BH} = 0.6$ mm/kW. Notably, changing the lower or side insulation in a hotzone can also achieve the desired temperature condition, and thus, influence the melt-solid interface shape. In one embodiment, the crystal growing apparatus includes a primary heater and a secondary heater. The primary heater is for example a side heater (not shown) and provides diameter control adjustment. The secondary heater is, for example, bottom heater 56 and provides melt gradient and interface shape control. That is, the secondary heater is adjusted according to the heater power set point to change the temperature gradient of the melt to control shape of melt-solid interface.

In another embodiment, the CPU 71 is responsive to the desired melt-solid interface shape profile 302 and the determined length by the storage of a determined magnet power set point. The PLC 69 is responsive to the magnet power set point to generate a magnet control signal 92 to supply to the magnet power supply 85. The magnet power supply 85 is responsive to the magnet control signal 92 to control the current being supplied to coils of a magnet 57 surrounding the crucible 19 to control the magnet field being applied to the melt 29. In particular, the application of a magnetic field provides a means of controlling the melt-solid interface shape along with the oxygen concentration.

It has been discovered that by, decreasing the magnetic field strength, the melt-solid interface height increases. As a result, increasing, or decreasing, the power supplied to the magnet by an amount that yields the desired change in the magnetic field can achieve a desired change in center height 502 of the interface. For example, decreasing the magnetic field fifteen percent (15%) by decreasing the current, and thus power, to the magnet, increases the center height 502 of the interface shape approximately 2.5 mm. (See Fig. 5C). Thus, the estimated gain in interface height with respect to the change in field strength, is $G_B$ = -0.167 mm/%. The magnet intensity is defined in relative units of field strength for a particular hotzone process. In this case, a value of 100% cusp magnetic field corresponds to 1000G axial field at the bottom center of a 200mm deep melt, with zero axial field at the top center of the melt. The maximum current is 750 Amps per coil

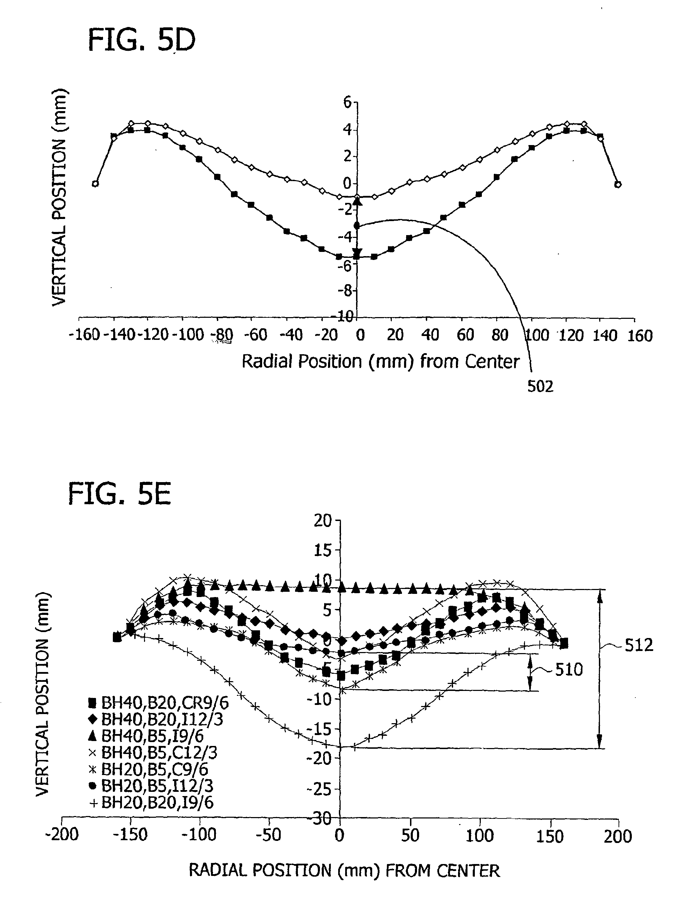

In one embodiment, the CPU is responsive to the desired melt-solid interface shape profile 302 and the determined length by the storage of a determined crucible rotational speed set point and crystal rotational speed set point. The PLC 69 is responsive to linearly compute intermediate crucible rotational speed set point and the crystal rotational speed set points, based on the target values at selected crystal lengths to generate a crucible rotation control signal 94 and crystal rotation control signal 94 to supply to the crucible drive unit 45 and crystal drive unit 49, respectively. As a result, the relative rotational rate, or delta rotation, between the crucible 19 and crystal 3 1 is controlled to control the interface shape. Where the relative rotation rate refers to the absolute difference between the absolute crystal rotation rate and absolute crucible rotation rate, (i.e., ‖seed rotation -|crucible rotation|). It has been discovered that, an increase in delta rotation increases the interface height; while a decrease in delta rotation decreases the interface height 502. As a result, a desired change in the center height of the interface height can be achieved by controlling the rotational speed differential between the crystal and the crucible. For example, increasing the rotational speed differential by two (2) revolutions per minute, increases the center height 502 of the interface shape approximately 4.5mm. (See Fig. 5D) The magnitude of the change is a function of absolute rotation rates of crystal and crucible. The estimated gain in interface height with respect to the change in delta rotation, is $G_{Rot}$ = 2.25 mm/rpm. In this instance, both the crucible 19 and crystal 31 are rotated in the same direction; iso rotation.

In another embodiment, the crucible 19 is rotated in one direction and the crystal 31 is rotated in the same direction to improve the range over which the melt-solid interface shape can be controlled. FIG 5E illustrates exemplary ranges over which the melt-solid interface shape can be controlled during and counter rotation and iso-rotation processes as indicated by double arrows 510, 512, respectively. As described above, an important parameter for controlling the melt-solid interface shape is the convection path of the molten silicon melt 29 within the crucible 19. The convection path is driven by the forced convection due to the rotations of the crucible and the crystal. Moreover, the effect of Iso-rotation coupled with various process conditions has shown to provide an increase in the melt-solid interface operating range. In other words, the range over which the interface shapes can be increases dramatically. The absolute changes in interface shape and height are functions of hotzone, process parameters, and axial position of crystal. The interface height is defined as the vertical distance between the edge of the crystal and the center of the crystal. For the experimental hotzone, the range over which the interface height could be controlled increased by 356%, from 5.5 mm to 25.25 mm. Thus the change to Iso-rotation provides an improved dynamic range to increase or decrease the axial gradient at the interface.

Although the invention is described above in reference to controlling various parameters individually, the present invention includes controlling two or more of the parameters to achieve the desired melt-solid interface shape.

As described above in reference to FIG. 3A, the V/I simulator 300 can be fine tuned by growing a crystal 31 according to the defined profile and comparing simulated V/I transitions to actual V/I transitions in the grown crystal 31. In other words, the V/I simulator and control components of system 11 (i.e., PLC 69, CPU 71, memory 73) are used in combination to provide an open loop control system.

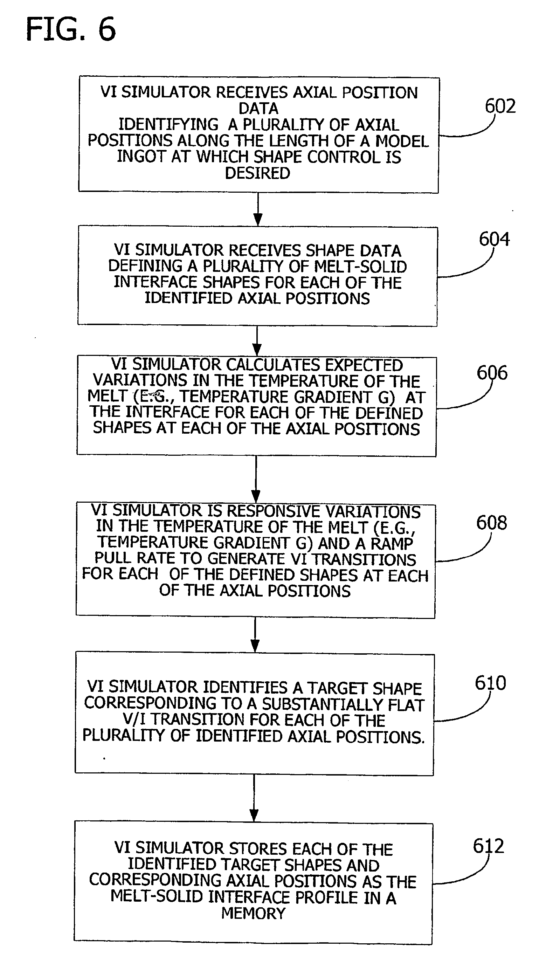

Referring now to FIG. 6, an exemplary flow chart illustrates a method for defining a melt-solid interface shape profile for use in combination with a crystal growing apparatus when growing a monocrystalline ingot according to the Czochralski process according to one embodiment of the invention. At 602, a V/I simulator 300 receives axial position data from an operator identifying a plurality of axial positions along the length of a model ingot at which shape control is desired. The V/I simulator 300 then receives shape data from the operator defining a plurality of melt-solid interface shapes for each of the identified axial positions at 604. At 606, the V/I simulator 300 is responsive to assumed processing parameters of the crystal growing apparatus (e.g., pull velocity, melt temperature, etc.), the identified axial positions and corresponding defined melt-solid interface shapes to define variations in the temperature of the melt at the interface. For example, the V/I simulator 300 calculates a temperature gradient G or across the interface or a temperature field in the crystal growing apparatus that corresponds to each of the defined melt-solid interface shapes. At 608, the V/I simulator 300 is responsive the calculated temperature gradient G to calculate the ratio between a defined velocity $v_p$ and the

calculated temperature gradient G. In this case, the defined velocity $v_p$ corresponds to a velocity profile stored in a memory and defines a ramped pull rate. As describe above, during a dynamic growth process (i.e., varying v/G), point defects within the growing silicon crystal can change from being vacancy dominated to interstitial dominated, or vice versa, and there is an identifiable V/I transition associated with such a change. By using a ramped pull rate, the simulated ingot is forced to transition from vacancy dominated to interstitial dominated, and the V/I simulator 300 generates a V/I transition that corresponds to each of the defined melt-solid interface shapes for each of the identified axial positions at 610. At 612, the V/I simulator 300 identifies a target shape that corresponds to a substantially flat V/I transition for each of the plurality of identified axial positions. The V/I simulator 300 stores each of the identified target shapes and corresponding axial positions as the melt-solid interface profile in a memory.

In operation, a system for use in combination with a crystal growing apparatus for growing a monocrystalline ingot according to the Czochralski process has a memory storing a pre-computed set of process parameter setpoint values at various crystal lengths that achieve or nearly achieve a desired melt-solid interface profile. The melt-solid interface profile represents a desired shape of a melt solid interface between the melt and the ingot during pulling as a function of a length of the ingot. A set of process gains allow estimation of operating parameters of the crystal growing apparatus as a function of the length of the ingot during pulling. Also, a controller is responsive to the determined operating parameter set point to adjust the operation condition of the crystal growing apparatus according to the determined operating parameter set point to control the shape of the melt-solid interface while the ingot is being pulled from the melt.

In defining the melt-solid interface shape profile, the process parameters may be selected based on actual oscillatory seed lift used to grow a crystal. In this instance, the actual interface shape may be confirmed, by a method of precipitation, bulk etching, and decorative etching or lifetime measurement. This embodiment of the present invention permits adjustment of the interface shape on subsequent crystals to closely achieve the desired interface shape at various crystal lengths. The seed lift profile may be changed from an oscillatory profile to a smooth profile based on the seed lift values experimentally determined where low or zero microdefect density is present (i.e., at the V/I transition boundary). The production of substantially radially-perfect or radially low defect silicon may be achieved, where small seed lift bias or profile adjustments are used to maintain low or zero microdefect levels, particularly where no interstitial loops or large vacancy clusters (as identified by D-defect or other measurements) occur.

APPENDIX A

**Method of Defining Operating Window**

The cooling rates through the temperature between 1150°C and 1000°C determine the maximum possible acceptable operating window for the process. The operating window is defined in terms of pull-rates. Suppose the mean pull-rate of a crystal at a location is x mm/min, a maximum operating window of y mm/min means that substantially microdefect free crystal at the chosen location can be produced within the pull-rate range between x+y/2 mm/min and x-y/2 mm/min. This is determined as follows.

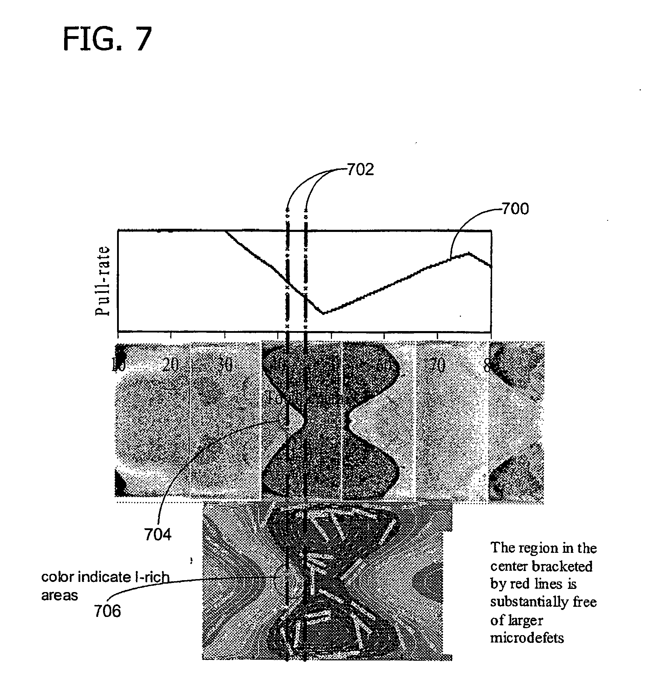

A crytsal is grown with a varying pull-rate profile 700, as shown in FIG. 7, in a hot-zone with known cooling rates through the temperature range between 1150°C and 1000°C. It is then characterized to identify the substantially microdefect free region in the center, which is bracketed by the lines 702. Various characterization techniques such as FPD measurements can be applied. The actual interface shape of the crystal, as indicated by 704, near the substantially microdefect free region is measured. This interface shape is used to simulate the point defect distribution using the point defect simulator. The point defect simulator provides the excess point defect concentrattion field Cv-Ci as indicated by reference character 706, where Cv is the vacancy concentration and Ci is the interstitial concentration. A positive Cv-Ci indicates vacancy rich region; a negative Cv-Ci indicates interstitial rich region. Moreover, higher the Cv-Ci in a region, larger than the vacancy-type microdefects formed; lower (but positive) the Cv-Ci in a region, the smaller the vacancy-type micrdodefects formed. If Cv-Ci is negative but higher in magnitude, larger interstitial-type microdefects are formed. Thus, for given cooling rates between 1150°C and 1000°C, there exists a region bracketed by positive Cv-Ci and a negative Cv-Ci, which is subtantially microdefect free. This substantially microdefect free can contain microdefects smaller than 30 nm. This maximum operating window is determined by comparing the experimentally determined substantially microdefect free region and the Cv-Ci field predicted by the point defect simulator. This defined the maximum operating window for the given cooling rates.

Any circular disc cut from the shown cylindrical ingot at any axial location is still not completely substantially microdefect free. Since wafers produced from the ingot rate circular discs, real operating window is defined by the width of the ingot that is substantially microdefect free everywhere along the radial location, i.e., from its center to the edge. This is called the real operating window. Changing the interface shape for a given cooling rate can vary this real operating window. An acceptable interface shape giving an acceptable operating window of at least 0.005 mm/min, preferably 0.01 mm/min, and most preferably 0.02 mm/min or higher is determined first by the point defect simulator, and then by the actual crystal growth. Any interface allowing the production of subtantially microdefect free circular discs is defined as accpetable.

**Claims**

1. A method for use in combination with a crystal growing apparatus for growing a monocrystalline ingot according to the Czochralski process, said crystal growing apparatus having a heated crucible containing a semiconductor melt from which the ingot is pulled, said ingot being grown on a seed crystal pulled from the melt, said method comprising the steps of:

   defining a melt-solid interface shape profile, said melt-solid interface shape profile representing a plurality of desired shapes of a melt-solid interface between the melt and the ingot during pulling as a function of the length of the ingot and an operating condition affecting the melt;
   determining a particular axial position along the length of the ingot, said axial position along the length of the ingot corresponding to at least one of the plurality of desired shapes in the defined melt-solid interface shape profile;
   determining a set point for an operating parameter of the crystal growing apparatus for controlling the operating condition affecting the melt at the axial position along the length of the ingot during pulling, said set point being specified by the melt-solid interface shape profile; and
   adjusting the operating condition of the crystal growing apparatus according to the determined operating parameter set point to control the melt-solid interface for achieving the desired shape at the axial position while the ingot is being pulled from the melt.

2. The method of Claim 1 wherein the operating condition is one or more of the following:

   temperature of the melt;
   magnetic field within the crucible;
   rotational speed of the ingot;
   rotational direction of the ingot;
   rotational speed of the crucible; and
   rotational direction of the crucible.

3. The method of Claim 1 or 2 wherein the operating parameter set point is one or more of the following:

   a heater power set point for a heater power supply of the crystal growing apparatus;
   a magnet power set point for a magnet power supply of the crystal growing apparatus;
   a crucible rotational speed set point for a crucible drive unit of the crystal growing apparatus; and
   a crystal rotational speed set point for the crystal drive unit of the crystal growing apparatus.

4. The method of Claim 3, wherein adjusting the operating condition according to the determined operating parameter set point includes adjusting power supplied to a heater of the crystal growing apparatus according to the heater power set point to change a temperature gradient of the melt to control the shape of melt-solid interface.

5. The method of Claim 3, wherein adjusting the operating condition according to the determined operating parameter set point includes adjusting power supplied to a magnet of the crystal growing apparatus according to the magnet power set point to change the convection of the melt to control the shape of melt-solid interface.

6. The method of Claim 3, wherein adjusting the operating condition according to the determined operating parameter set point includes adjusting power supplied to the crucible drive unit of the crystal growing apparatus according to the crucible rotational speed set point and adjusting the power supplied to the crystal drive unit of the crystal growing apparatus according to the crystal rotational speed set point to change the convection of the melt to control the shape of melt-solid interface.

7. The method of any one of Claims 1 to 6, wherein the crucible and ingot are rotated in opposite directions to control the shape of melt-solid interface.

8. The method of any one of Claims 1 to 6, wherein the crucible and ingot are rotated in a same direction to control the shape of melt-solid interface.

9.  The method of any one of Claims 1 to 8, wherein the set point for the operating parameter is determined for a selected hotzone of the crystal growing apparatus having a pre-computed crystal thermal boundary condition.

10. The method of any one of Claims 1 to 8, wherein defining the melt-solid interface shape profile includes:

    selecting a plurality of axial positions along the length of a model ingot;
    defining a plurality of melt-solid interface shapes for each of the identified axial positions;
    determining a thermal model of a hotzone of the crystal growing apparatus for each of the axial positions and each of the melt-solid interface shapes;
    defining a velocity profile representative of a ramped pull rate;
    determining a point defect model representative of one or more point defects occurring in a region of the model ingot; said point defect model being responsive to the velocity profile and the thermal model for identifying a V/I transition for each of the plurality of defined melt solid interface shapes for each of the plurality of identified axial positions; and
    identifying a desired melt-solid interface shape corresponding to a substantially flat V/I transition for each of the plurality of identified axial positions.

11. The method of Claim 10 further comprising storing each of the identified desired shapes and corresponding axial positions in the melt-solid interface shape profile.

12. The method of Claim 10, wherein defining a thermal model comprises defining an interface shape response model representative of a change in hotzone thermal characteristics.

13. A system for use in combination with a crystal growing apparatus for limiting formation of defects during growing a monocrystalline ingot according to the Czochralski process, said crystal growing apparatus having a heated crucible containing a semiconductor melt from which the ingot is pulled, said ingot being grown on a seed crystal pulled from the melt, said crystal growing apparatus further having a controller for adjusting an operating condition of the crystal growing apparatus, said system comprising:

    a memory storing a pre-defined melt-solid interface profile, said melt-solid interface profile representing a plurality of desired shapes of a melt solid interface between the melt and the ingot during pulling as a function of a length of the ingot and an operating condition affecting the melt;
    a processor responsive to the pre-defined melt-solid interface profile for determining a particular axial position along the length of the ingot corresponding to at least one of the plurality of desired shapes in melt-solid shape interface profile and determining a set point for an operating parameter of the crystal growing apparatus for controlling the operating condition affecting the melt at the axial position along the length of the ingot during pulling; and
    wherein said controller is responsive to the determined operating parameter set point to adjust the operation condition of the crystal growing apparatus according to the determined operating parameter set point to control the melt-solid interface for achieving the desired shape at the axial position while the ingot is being pulled from the melt.

14. The system of Claim 13, wherein the operating condition is one or more of the following:

    temperature of the melt;
    magnetic field within the crucible
    rotational speed of the ingot;
    rotational direction of the ingot;
    rotational speed of the crucible; and
    rotational direction of the crucible.

15. The system of Claim 13 or 14, wherein the determined operating parameter set point is one or more of the following:

    a heater power set point for a heater power supply of the crystal growing apparatus;
    a magnet power set point for a magnet power supply of the crystal growing apparatus;
    a crucible rotational speed set point for a crucible drive unit of the crystal growing apparatus; and
    a ingot rotational speed set point for a crystal drive unit of the crystal growing apparatus.

**16.** The system of Claim 15, wherein the controller is configured to adjust one or more of the following in response to the determined operating parameter to control the shape of the melt-solid interface:

power supplied to a heater of the crystal growing apparatus according to the heater power set point to change a temperature gradient of the melt to control the shape of the melt-solid interface; and
power supplied to a magnet of the crystal growing apparatus according to the magnet power set point to change the convection of the melt to control the shape of the melt-solid interface.

**17.** The system of any one of Claims 13 to 16, wherein the controller is configured to adjust the power supplied to a crucible drive unit of the crystal growing apparatus according to the crucible rotational speed set point and adjust the power supplied to a crystal drive unit of the crystal growing apparatus according to the crystal rotational speed set point to change the convection of the melt to control the shape of the melt-solid interface.

**18.** The system of any one of Claims 13 to 17 further comprising a V/I simulator for pre-defining the melt-solid interface shape profile, and wherein the V/I simulator includes a temperature model for generating a temperature gradient for each of a plurality of melt-solid interface shapes at each of a plurality of axial positions along the length of the crystal. a velocity profile stored in a memory and defining a ramped pull rate;
a point defect model is responsive to the velocity profile and the temperature model to generate an expected V/I transition representative of the transition from an excess vacancy dominant region to an excess interstitial dominant region for each of the plurality of defined melt-solid interface shapes, wherein an operator examines the generated V/I transitions to identify a target shape corresponding to a substantially flat V/I transition for each of the plurality of identified axial positions for storage as a melt-solid interface profile in a memory.

**Patentansprüche**

**1.** Verfahren zur Anwendung in Verbindung mit einer Kristall züchtungsapparatur zur Züchtung eines einkristallinen Blocks nach dem Czochralski-Prozess, wobei die Kristallzüchtungsapparatur einen beheizten Tiegel hat mit einer Halbleiterschmelze darin, aus der der Block gezogen wird, und der Block auf einem aus der Schmelze gezogenen Kristallzuehtkeim gezüchtet wird, mit den Stufen der
Definition eines Schmelze-Feststoff-Grenzflächenformprofils, das eine Mehrzahl erwünschter Formen einer Schmelze-Feststoff-Grenzfläche zwischen der Schmelze und dem Block während des Ziehens als Funktion der Blocklänge und eines die Schmelze beeinflussenden Betriebszustands darstellt,
Bestimmung einer besonderen axialen Position längs der Blocklänge, wobei die axiale Position längs der Blocklänge wenigstens einer aus der Mehrzahl erwünschter Formen in dem definierten Schmelze-Fest stoff-Grenzflächenformprofil entspricht,
Bestimmung eines Einstellwerts für einen Betriebsparameter der Kristallzüchtungsapparatur zur Steuerung des die Schmelze beeinflussenden Betriebszustands an der axialen Position längs der Blocklänge während des Ziehens, wobei der Einstellwert durch das Schmelze-Feststoff-Grenzflächenformprofil spezifiziert ist, und
Einstellung des Betriebszustands der Kristallzüchtungsapparatur nach dem bestimmten Einstellwert des Betriebsparameters, um die Schmelze-Feststoff-Grenzfläche zur Erlangung der erwünschten Form an der axialen Position beim Blockziehen aus der Schmelze zu steuern.

**2.** Verfahren des Anspruchs 1, bei dem der Betriebszustand einer oder mehrere der folgenden ist :

Temperatur der Schmelze,
Magnetfeld in dem Tiegel,
Drehzahl des Blocks,
Drehrichtung des Blocks,
Drehzahl des Tiegels und
Drehrichtung des Tiegels.

**3.** Verfahren des Anspruchs 1 oder 2, bei dem der Einstellwert des Betriebsparameters einer oder mehrere der folgenden ist:

ein Einstellwert; der Heizleistung für eine Heizleistungsversorgung der Kristallzüchtungsapparatur,
ein Einstellwert der Magnetleistung für eine Magnetleistungsversorgung der Kristallzüchtungsapparatur,
ein Einstellwert der Tiegeldrehzahl für eine Tiegelantriebseinheit der Kristallzüchtungsapparatur und

ein Einstellwert der Kristalldrehzahl für die Kristallantriebseinheit der Kristallzüchtungsapparatur.

4. Verfahren des Anspruchs 3, bei dem die Einstellung des Betriebszustands nach dem bestimmten Einstellwert des Betriebsparameters die Einstellung der einer Heizeinrichtung der Kristallzüchtungsapparatur gemäß dem Heizleistungseinstellwert zur Änderung eines Temperaturgradienten der Schmelze zugeführten Leistung beinhaltet, um die Form der Schmelze-Feststoff-Grenzfläche zu steuern.

5. Verfahren des Anspruchs 3, bei dem die Einstellung des betriebeszustands nach dem bestimmten Einstellwert, des Betriebsparameters die Einstellung der einem Magneten der Kristallzüchtungsapparatur gemäß dem Magnetleistungseinstellwert zugeführten Leistung beinhaltet, um zur Steuerung der Form der Schmelze-Feststoff-Grenzfläche die Konvektion der Schmelze zu ändern.

6. Verfahren des Anspruchs 3, bei dem die Einstellung des Betriebszustands nach dem bestimmten Einstellwert; des Betriebsparameters die Einstellung der der Tiegelantriebseinheit der Kristallzüchtungsapparatur gemäß dem Einstellwert der Tiegeldrehzahl zugeführten Leistung und die Einstellung der der Kristallantriebseinheit der Kristallzüchtungsapparatur gemäß dem Einstellwert; der Kristalldrehzahl zugeführten Leistung beinhaltet, um zur Steuerung der Form der Schmelze-Feststoff-Grenzfläche die Konvektion der Schmelze zu ändern.

7. Verfahren eines der Ansprüche 1 bis 6, bei dem der Tiegel und der Block in entgegengesetzten Richtungen gedreht werden, um die Form der Schmelze-Feststoff-Grenzfläche zu steuern.

8. Verfahren eines der Ansprüche 1 bis 6, bei dem der Tiegel und der Block in der gleichen Richtung gedreht werden, um die Form der Schmelze-Feststoff-Grenzfläche zu steuern.

9. Verfahren eines der Ansprüche 1 bis 8, bei dem der Einstellwert für den Betriebsparameter für eine ausgewählte heiße Zone der Kristallzüchtungsapparatur mit einem vorberechneten thermischen Grenzschichtzustand des Kristalls bestimmt wird.

10. Verfahren eines der Ansprüche 1 bis 8, bei dem die Definition des Schmelze-Feststoff-Grenzflächenformprofils beinhaltet:

Auswahl einer Mehrzahl axialer Positionen längs der Länge eines Modellblocks,
Definition einer Mehrzahl von Schmelze-Feststoff-Crenzflächenformen für jede der identifizierten axialen Positionen,
Bestimmung eines Temperaturmodells einer heißen Zone der Kristallzüchtungsapparatur für jede der axialen Positionen und jede der Schmelze-Feststoff-Grenzflächenformen,
Definition eines Geschwindigkeitsprofils, das eine ansteigende Ziehgeschwindigkeit darstellt,
Bestimmung eines Punktfehlstellenmodells, das eine oder mehrere in einem Bereich des Modellblocks auftretende darstellt, wobei das Punktfehlstellenmodell dem Geschwindigkeitsprofil und dem thermischen Modell gehorcht zur Identifizierung eines V/I-Übergangs für jede aus der Mehrzahl definierter Schmelze-Feststoff-Grenzflächenformen für jede der Mehrzahl identifizierter axialer Positionen, und
Identifizierung einer erwünschten Schmelze-Feststoff-Grenzflächenforme entsprechend einem im wesentlichen flachen V/I-Übergang für jede der Mehrzahl identifizierter axialer Positionen.

11. Verfahren des Anspruches 10, ferner mit Speicherung jeder der identifizierten erwünschten Formen und entsprechende axialen Positionen in dem Schmelze-Feststoff-Grenzflächenformprofil.

12. Verfahren des Anspruches 10, bei dem die Definition eines thermischen Modells die Definition eines Grenzflächenformreaktionsmodells umfaßt, das eine Änderung der thermischen Kennwerte der heißen Zone darstellt.

13. System zur Benützung in Verbindung mit einer Kristallzüchtungsapparatur zur Begrenzung der Fehlstellenbildung beim Züchten eine einkristallinen Blocks nach dem Czochralski-Prozess, wobei die Kristallzüchtungsapparatur einen beheizten Tiegel hat mit einer Halbleiterschmelze darin, aus der der Block gezogen wird, und der Block auf einem aus der Schmelze gezogenen Kristallzuchtkeim gezüchtet wird und die Kristallzüchtungsapparatur ferner ein Steuergerät zur Einstellung eines Betriebszustands der Kristallzüchtungsapparatur hat, wobei das System umfaßt:

einen Speicher, der ein vordefiniertes Schmelze-Feststoff-Grenzflächenprofil speichert, das mehrere erwünschte Formen einer Schmelze-Feststoff-Grenzfläche zwischen der Schmelze und dem Blocks während des Ziehens als Funktion einer Blocklänge und eines die Schmelze beeinflussenden Betriebszustands darstellt,
einen auf das vordefinierte Schmelze-Feststoff-Grenzflächenprofil ansprechenden Prozessor zur Bestimmung einer besonderen axialen Position längs der Blocklänge entsprechend wenigstens einer aus der Mehrzahl erwünschter Formen in dem Schmelze-Feststoff-Grenzflächenformprofil und zur Bestimmung eines Einstellwerts für einen Betriebsparameter der Kristallzüchtungsapparatur zur Steuerung des die Schmelze beeinflussenden Betriebszustands an der axialen Position längs der Blocklänge während des Ziehens, und
wobei das Steuergerät auf den bestimmten Einstellwert des Betriebsparameters anspricht, um den Betriebszustand der Kristallzüchtungsapparatur nach dem bestimmten Einstellwert des Betriebsparameters zur Steuerung der Schmelze-Feststoff-Grenzfläche einzustellen, um beim Ziehen des Blocks aus der Schmelze die erwünschte Form an der axialen Position zu erhalten.

**14.** System des Anspruchs 13, bei dem der Betriebszustand einer oder mehrere der folgenden ist :

    Temperatur der Schmelze,
    Magnetfeld in dem Tiegel,
    Drehzahl des Blocks,
    Drehrichtung des Blocks,
    Drehzahl des Tiegels und
    Drehrichtung des Tiegels.

**15.** System des Anspruchs 13 oder 14, bei dem der bestimmte Einstellwert des Betriebsparameters einer oder mehrere der folgenden ist:

    ein Einstellwert der Heizleistung Für eine neizleistungsversorgung der Kristallzüchtungsapparatur,
    ein Einstellwert der Magnetleistung für eine Magnet leistungsversorgung der Kristallzüchtungsapparatur,
    ein Einstellwert der Tiegeldrehzahl für eine Tiegelantriebseinheit der Kristallzüchtungsapparatur und
    ein Einstellwert der Kristalldrehzahl für die Kristallantriebseinheit der Kristallzüchtungsapparatur.

**16.** System des Anspruches 15, bei dem das Steuergerät zur Einstellung einer oder mehrerer der folgenden Größen in Reaktion auf den bestimmten Betriebsparameter eingerichtet, ist, um die Form der Schmelze-Feststoff-Grenzfläche zu steuern:

    Leistung, die einem Erhitzer der Kristallzüchtungsapparatur gemäß dem Einstellwert der Erhitzerleistung zwecks Änderung eines Temperaturgradient en der Schmelze zugeführt wird, um die Form der Schmelze-Feststoff-Grenzfläche zu steuern, und
    Leistung, die einem Magneten der Kristallzüchtungsapparatur gemäß dem Einstellwert der Magnetleistung zwecks Änderung der Konvektion der Schmelze zugeführt wird, um die Form der Schmelze-Feststoff-Grenzfläche zu steuern.

**17.** System eines der Ansprüche 13 bis 16, bei dem das Steuergerät eingereichtet ist, um die einer Tiegelantriebseinheit der Kristallzüchtungsapparatur gemäß dem Einstellwert der Tiegeldrehzahl zugeführte Leistung einzustellen und die einer Kristallantriebseinheit der Kristallzüchtungsapparatur gemäß dem Einstellwert der Kristalldrehzahl zugeführte Leistung einzustellen, um zur Steuerung der Form der Schmelze-Feststoff-Grenzfläche die Konvektion der Schmelze zu wandern.

**18.** System eines der Ansprüche 13 bis 17, ferner mit einem V/I-Simulator für das Vordefinierten des Schmelze-Feststoff-Grenzflächenformprofils, und bei dem der V/I-Simulator ein Temperaturmodell zur Generierung eines Temperaturgradienten für jede aus einer Mehrzahl von Schmelze-Feststoff-Grenzflächenformen an jeder einer Mehrzahl axialer Positionen längs der Kristalllänge beinhaltet,
einem in einem Speicher gespeicherten Geschwindigkeitsprofil, das eine ansteigende Ziehgeschwindigkeit definiert,
einem Punktfehlstellenmodell, das auf das Geschwindigkeitsprofil und das Temperaturmodell anspricht, um einen für den Übergang von einem Überschußleerstellen-dominanten Bereich zu einem Überschußzwischengitteratom-dominanten Bereich repräsentativen, erwarteten V/I-Übergang für jede der Mehrzahl definierter Schmelze-Feststoff-Grenzflächenformen zu generieren, wobei eine Bedienungsperson die generierten V/I-Übergänge prüft, um für jede der Mehrzahl identifizierter axialer Positionen zur Speicherung als Schmelze-Feststoff-Grenzflächenprofil in einem Speicher eine Zielform entsprechend einem im wesentlichen flachen V/I-Übergang zu identifizieren.

**Revendications**

1. Procédé à utiliser en association avec un dispositif pour la croissance d'un cristal pour faire croître un lingot monocristallin selon le procédé de Czochralski, ledit dispositif pour la croissance d'un cristal étant équipé d'un creuset chauffé contenant une phase fondue semi-conductrice à partir de laquelle le lingot est obtenu par tirage, ledit lingot croissant sur un germe de cristal tiré de la phase fondue, ledit procédé comprenant les étapes de :

   définition d'un profil de forme d'interface phase fondue-solide, ledit profil de forme d'interface phase fondue-solide représentant plusieurs formes recherchées d'interface phase fondue-solide entre la phase fondue et le lingot au cours du tirage en fonction de la longueur du lingot et d'une condition opératoire affectant la phase fondue ;
   détermination d'une position axiale particulière dans le sens de la longueur du lingot, ladite position axiale dans le sens de la longueur du lingot correspondant à au moins une des plusieurs formes recherchées dans le profil de forme d'interface phase fondue-solide défini ;
   détermination d'une valeur de consigne d'un paramètre opératoire du dispositif pour la croissance d'un cristal pour contrôler la condition opératoire affectant la phase fondue selon la position axiale dans le sens de la longueur du lingot au cours du tirage, ladite valeur de consigne étant spécifiée par la forme de l'interface phase fondue-solide ; et
   ajustement de la condition opératoire du dispositif pour la croissance d'un cristal selon la valeur de consigne de paramètre opératoire déterminée pour contrôler l'interface phase fondue-solide pour atteindre la forme recherchée selon la position axiale alors que le lingot est tiré de la phase fondue.

2. Procédé selon la revendication 1, dans lequel la condition opératoire est une ou plusieurs des suivantes :

   température de la phase fondue ;
   champ magnétique dans le creuset ;
   vitesse de rotation du lingot ;
   direction de rotation du lingot ;
   vitesse de rotation du creuset ; et
   direction de rotation du creuset.

3. Procédé selon la revendication 1 ou 2, dans lequel la valeur de consigne de paramètre opératoire déterminée est une ou plusieurs des suivantes :

   une valeur de consigne de puissance de chauffage pour l'alimentation du système de chauffage du dispositif pour la croissance d'un cristal ;
   une valeur de consigne de puissance magnétique pour l'alimentation du système magnétique du dispositif pour la croissance d'un cristal ;
   une valeur de consigne de vitesse de rotation du creuset pour le mécanisme de commande du creuset du dispositif pour la croissance d'un cristal ; et
   une valeur de consigne de vitesse de rotation du cristal pour le mécanisme de commande du cristal de l'appareil de croissance de cristal.

4. Procédé selon la revendication 3, dans lequel l'ajustement de la condition opératoire selon la valeur de consigne de paramètre opératoire déterminée comprend l'ajustement de l'alimentation de puissance du système de chauffage du dispositif pour la croissance d'un cristal selon la valeur de consigne de puissance de chauffage pour faire varier le gradient de température de la phase fondue pour contrôler la forme de l'interface phase fondue-solide.

5. Procédé selon la revendication 3, dans lequel l'ajustement de la condition opératoire selon la valeur de consigne de paramètre opératoire déterminée comprend l'ajustement de l'alimentation de puissance de l'aimant du dispositif pour la croissance d'un cristal selon la valeur de consigne de puissance magnétique pour faire varier la convection de la phase fondue pour contrôler la forme de l'interface phase fondue-solide.

6. Procédé selon la revendication 3, dans lequel l'ajustement de la condition opératoire selon la valeur de consigne de paramètre opératoire déterminée comprend l'ajustement de l'alimentation de puissance du mécanisme de commande du creuset du dispositif pour la croissance d'un cristal selon la valeur de consigne de vitesse de rotation du creuset et l'ajustement de l'alimentation de puissance du mécanisme de commande du cristal du dispositif pour la croissance d'un cristal selon la valeur de consigne de vitesse de rotation du cristal pour faire varier la convection de la phase fondue pour contrôler la forme de l'interface phase fondue-solide.

7. Procédé selon l'une quelconque des revendications 1 à 6, dans lequel le creuset et le lingot sont en rotation dans des directions opposées pour contrôler la forme de l'interface phase fondue-solide.

8. Procédé selon l'une quelconque des revendications 1 à 6, dans lequel le creuset et le lingot sont en rotation dans la même direction pour contrôler la forme de l'interface phase fondue-solide.

9. Procédé selon l'une quelconque des revendications 1 à 8, dans lequel la valeur de consigne du paramètre opératoire est déterminée pour une zone chaude choisie du dispositif pour la croissance d'un cristal présentant une valeur préenregistrée de limite de transfert thermique au cristal.

10. Procédé selon l'une quelconque des revendications 1 à 8, dans lequel la définition du profil de forme de l'interface phase fondue-solide comprend :

la sélection de plusieurs positions axiales dans le sens de la longueur d'un lingot modèle ;
la définition de plusieurs formes d'interface phase fondue-solide pour chacune des positions axiales identifiées ;
la détermination d'un modèle thermique de zone chaude du dispositif pour la croissance d'un cristal pour chacune des positions axiales et chacune des formes de l'interface phase fondue-solide;
la définition d'un profil de vitesse représentatif d'une tirée de filière graduelle ;
la détermination d'un modèle de défaut ponctuel représentatif d'un ou plusieurs défauts ponctuels se produisant dans une région du lingot modèle ; ledit modèle de défaut ponctuel étant sensible au profil de vitesse et au modèle thermique pour l'identification d'une transition V/I pour chacune des plusieurs formes d'interface phase fondue-solide définies pour chacune des plusieurs positions axiales identifiées ; et
l'identification d'une forme d'interface phase fondue-solide cible correspondant à une transition V/I essentiellement uniforme pour chacune des plusieurs positions axiales identifiées.

11. Procédé selon la revendication 10 comprenant de plus le stockage de chacune des formes et des positions axiales correspondantes recherchées identifiées dans le profil de forme de l'interface phase fondue-solide.

12. Procédé selon la revendication 10, dans lequel la définition d'un modèle thermique comprend la définition d'un modèle de réponse de forme de l'interface représentatif d'une variation des caractéristiques thermiques de la zone chaude.

13. Système pour utilisation en association avec un dispositif pour la croissance d'un cristal pour limiter la formation de défauts au cours de la croissance d'un lingot monocristallin selon le procédé de Czochralski, ledit dispositif pour la croissance d'un cristal étant équipé d'un creuset chauffé contenant une phase fondue semi-conductrice à partir de laquelle le lingot est obtenu par tirage, ledit lingot croissant sur un germe de cristal tiré de la phase fondue, ledit dispositif pour la croissance d'un cristal étant en outre équipé d'un régulateur pour ajuster une condition opératoire du dispositif pour la croissance d'un cristal, ledit système comprenant :

une mémoire stockant un profil d'interface phase fondue-solide prédéfini, ledit profil d'interface phase fondue-solide représentant plusieurs formes recherchées d'interface phase fondue-solide entre la phase fondue et le lingot au cours du tirage en fonction de la longueur du lingot et des conditions opératoires affectant la phase fondue ;
un processeur sensible au profil prédéfini d'interface phase fondue-solide pour déterminer une position axiale particulière dans le sens de la longueur du lingot correspondant à au moins une des plusieurs formes recherchées du profil d'interface phase fondue-solide et pour déterminer une valeur de consigne d'un paramètre opératoire du dispositif pour la croissance d'un cristal pour contrôler la condition opératoire affectant la phase fondue dans la position axiale dans le sens de la longueur du lingot au cours du tirage ; et
dans lequel ledit régulateur est sensible à la valeur de consigne de paramètre opératoire déterminée pour ajuster la condition opératoire du dispositif pour la croissance d'un cristal selon la valeur de consigne déterminée du paramètre opératoire pour contrôler l'interface phase fondue-solide pour atteindre la forme recherchée dans la position axiale lorsque le lingot est obtenu par tirage de la phase fondue.

14. Système selon la revendication 13, dans lequel la condition opératoire est une ou plusieurs des suivantes :

température de la phase fondue ;

champ magnétique dans le creuset ;
vitesse de rotation du lingot ;
direction de rotation du lingot ;
vitesse de rotation du creuset ; et
direction de rotation du creuset.

15. Système selon la revendication 13 ou 14, dans lequel la valeur de consigne de paramètre opératoire déterminée est une ou plusieurs des suivantes :

une valeur de consigne de puissance de chauffage pour l'alimentation du système de chauffage du dispositif pour la croissance d'un cristal ;
une valeur de consigne de puissance magnétique pour l'alimentation du système magnétique du dispositif pour la croissance d'un cristal ;
une valeur de consigne de vitesse de rotation du creuset pour le mécanisme de commande du creuset du dispositif pour la croissance d'un cristal ; et
une valeur de consigne de vitesse de rotation du lingot pour le mécanisme de commande du cristal de l'appareil de croissance de cristal.

16. Système selon la revendication 15, dans lequel le régulateur est configuré pour ajuster un ou plusieurs des points suivants en réponse au paramètre opératoire déterminé pour contrôler la forme de l'interface phase fondue-solide :

l'alimentation de puissance du système de chauffage du dispositif pour la croissance d'un cristal selon la valeur de consigne de puissance de chauffage pour faire varier le gradient de température de la phase fondue pour contrôler la forme de l'interface phase fondue-solide ; et
l'alimentation de puissance de l'aimant du dispositif pour la croissance d'un cristal selon la valeur de consigne de puissance magnétique pour faire varier la convection de la phase fondue pour contrôler la forme de l'interface phase fondue-solide.

17. Système selon l'une quelconque des revendications 13 à 16, dans lequel le régulateur est configuré pour ajuster l'alimentation de puissance du mécanisme de commande du creuset du dispositif pour la croissance d'un cristal selon la valeur de consigne de vitesse de rotation du creuset et pour ajuster l'alimentation de puissance du mécanisme de commande du cristal du dispositif pour la croissance d'un cristal selon la valeur de consigne de vitesse de rotation du cristal pour faire varier la convection de la phase fondue pour contrôler la forme de l'interface phase fondue-solide.

18. Système selon l'une quelconque des revendications 13 à 17, comprenant en outre un simulateur V/I pour le profil de forme prédéfini de l'interface phase fondue-solide, et dans lequel le simulateur V/I comprend :

un modèle de température pour générer un gradient de température pour chacune des plusieurs formes d'interface phase fondue-solide à chacune des plusieurs positions axiales dans le sens de la longueur du cristal ;
un profil de vitesse stocké dans une mémoire et définissant une tirée de filière graduelle ;
un modèle de défaut ponctuel sensible au profil de vitesse et au modèle de température pour générer une transition V/I attendue représentative d'une transition d'une région à dominante de vacances en excès à une région à dominante d'interstices en excès pour chacune des plusieurs formes définies d'interface phase fondue-solide, dans lequel un opérateur examine les transitions V/I générées pour identifier une forme cible correspondant à une transition V/I essentiellement uniforme pour chacune des plusieurs positions axiales identifiées pour le stockage dans une mémoire en tant que profil d'interface phase fondue-solide.

# FIG. 1

# FIG. 2

## FIG. 3A

## FIG. 3B

302

## FIG. 3C

# FIG. 3D

FIG. 3E

324

322

FIG. 4A

200 mm

400 mm

600 mm

402

800 mm

404

1000 mm

FIG. 4B

# FIG. 5A

## FIG. 5B

## FIG. 5C

## FIG. 5D

## FIG. 5E

# FIG. 6

VI SIMULATOR RECEIVES AXIAL POSITION DATA
IDENTIFYING A PLURALITY OF AXIAL POSITIONS ALONG THE LENGTH OF A MODEL INGOT AT WHICH SHAPE CONTROL IS DESIRED — 602

VI SIMULATOR RECEIVES SHAPE DATA DEFINING A PLURALITY OF MELT-SOLID INTERFACE SHAPES FOR EACH OF THE IDENTIFIED AXIAL POSITIONS — 604

VI SIMULATOR CALCULATES EXPECTED VARIATIONS IN THE TEMPERATURE OF THE MELT (E.G., TEMPERATURE GRADIENT G) AT THE INTERFACE FOR EACH OF THE DEFINED SHAPES AT EACH OF THE AXIAL POSITIONS — 606

VI SIMULATOR IS RESPONSIVE VARIATIONS IN THE TEMPERATURE OF THE MELT (E.G., TEMPERATURE GRADIENT G) AND A RAMP PULL RATE TO GENERATE VI TRANSITIONS FOR EACH OF THE DEFINED SHAPES AT EACH OF THE AXIAL POSITIONS — 608

VI SIMULATOR IDENTIFIES A TARGET SHAPE CORRESPONDING TO A SUBSTANTIALLY FLAT V/I TRANSITION FOR EACH OF THE PLURALITY OF IDENTIFIED AXIAL POSITIONS. — 610

VI SIMULATOR STORES EACH OF THE IDENTIFIED TARGET SHAPES AND CORRESPONDING AXIAL POSITIONS AS THE MELT-SOLID INTERFACE PROFILE IN A MEMORY — 612

# FIG. 7

The region in the
center bracketed
by red lines is
substantially free
of larger
microdefets

color indicate l-rich
areas
706

704

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 089662 A
- US 5766341 A

- WO 0022201 A